# EUROPÄISCHE PATENTSCHRIFT

(11) **EP 0 834 175 B1**
(45) Veröffentlichungstag und Bekanntmachung des Hinweises auf die Patenterteilung: **17.09.2003**
(21) Anmeldenummer: 97920519.2
(22) Anmeldetag: 15.03.1997
(51) Int. Cl.: G11C 16/06

(54) **VERFAHREN ZUM BETREIBEN EINES STEUERGERÄTES MIT EINER PROGRAMMIERBAREN SPEICHEREINRICHTUNG**
PROCESS FOR OPERATING A CONTROLLER WITH A PROGRAMMABLE MEMORY
PROCEDE D'UTILISATION D'UN APPAREIL DE COMMANDE POURVU D'UNE MEMOIRE PROGRAMMABLE

(30) Priorität: 23.04.1996 DE 19616053
(43) Veröffentlichungstag der Anmeldung: 08.04.1998
(73) Patentinhaber: ROBERT BOSCH GMBH, 70442 Stuttgart (DE)
(72) Erfinder: FACKLER, Rupert, D-74385 Pleidelsheim (DE); FRANZ, Carsten, D-71706 Markgroeningen (DE)
(86) Internationale Anmeldenummer: DE9700530
(87) Internationale Veröffentlichungsnummer: WO97040502

(56) Entgegenhaltungen:
- EP-A- 0 450 462
- DE-A- 4 013 727
- US-A- 4 117 974
- US-A- 5 278 759
- RESEARCH DISCLOSURE, Nr. 302, Juni 1989, Seite 415 XP000034742 "EEPROM ERASE AND WRITE SECURITY FOR ELECTRONIC CONTROL SYSTEMS"

## Beschreibung

Die vorliegende Erfindung betrifft ein Verfahren gemäß dem Oberbegriff des Patentanspruchs 1, d.h. ein Verfahren zum Betreiben eines Steuergerätes mit einer programmierbaren Speichereinrichtung, wobei das Programmieren der Speichereinrichtung unter aufeinanderfolgender Ausführung einer Vielzahl von Speicherprogrammierungs-Steuervorgängen erfolgt.

Ein derartiges Verfahren ist beispielsweise in der DE 43 32 499 A1 und in der Druckschrift US 5 278 759 offenbart. Das in dieser Druckschrift beschriebene Steuergerät ist ein Kraftfahrzeugsteuergerät mit programmierbaren, genauer gesagt löschbaren nichtflüchtigen Speichereinrichtungen in Form von Flash-EPROMs. Die Verwendung von Flash-EPROMs gewinnt zunehmend an Bedeutung, weil sie die Vorzüge eines "normalen" EPROM (hohe Speicherzellendichte auf engem Raum) und eines EEPROM (elektrisches und damit einfaches und bequemes Löschen des Speicherinhalts) in sich vereinen.

Zum anfänglichen Programmieren, d.h. Löschen und/oder Überschreiben der Flash-EPROMs (vorzugsweise in Abhängigkeit vom Kraftfahrzeug-Typ im Kraftfahrzeug-Herstellungsbetrieb) oder zur späteren Umprogrammierung derselben (beim Kundendienst zur Fehlerbeseitigung oder entsprechend individuellen Kundenwünschen) wird ein externes Programmiergerät, beispielsweise in Form eines Personal Computers an das Steuergerät angeschlossen. Durch ein derartiges Programmiergerät wird bei Bedarf das Ausführen von im Steuergerät gespeicherten Steuerprogrammen zum Löschen oder Überschreiben von Daten im Flash-EPROM veranlaßt und gegebenenfalls die neu einzuspeichernden Daten zur Verfügung gestellt.

Um ein mißbräuchliches oder versehentliches Löschen oder Überschreiben von Daten im Flash-EPROM zu verhindern, ist eine Reihe von Schutzmechanismen vorgesehen, die es zu überwinden gilt. So muß beispielsweise zuerst das externe Programmiergerät an das Steuergerät angeschlossen und eine entsprechende Kommunikation in Gang gebracht werden, bevor überhaupt erst einmal im Steuergerät das entsprechende Steuerprogramm zum Löschen und/oder Überschreiben von Inhalten des Flash-EPROMs aktivierbar ist. Auch bei der Ausführung des entsprechenden Steuerprogramms selbst sind noch verschiedene Hürden zu überwinden, um die Voraussetzungen dafür zu schaffen, daß das Flash-EPROM programmiert bzw. gelöscht werden kann (beispielsweise muß das Flash-EPROM durch Anlegen vorbestimmter Adressen- und/oder Datenkombinationen vor dessen Programmierung entriegelt werden).

Wenngleich eine Vielzahl von Maßnahmen vorgesehen ist, um ein versehentliches oder mißbräuchliches Löschen oder Überschreiben von Daten im Flash-EPROM zu verhindern, kann dies durch eine Verkettung unglücklicher Umstände gleichwohl geschehen.

Verantwortlich hierfür sind vor allem Störungen bzw. Fehlfunktionen des Steuergerätes und/oder des Programmiergerätes, welche beispielsweise durch Hardwarefehler, EMV-Einstrahlungen oder unter Umständen auch durch gezielte Manipulation zu Mißbrauchszwecken verursacht werden können.

Der vorliegenden Erfindung liegt daher die Aufgabe zugrunde, das Verfahren gemäß dem Oberbegriff des Patentanspruchs 1 derart weiterzubilden, daß ein durch Störungen ausgelöstes und/oder beeinflußtes Löschen und/oder Überschreiben von in einer programmierbaren Speichereinrichtung gespeicherten Daten auf einfache Weise weitestgehend ausschließbar ist.

Diese Aufgabe wird erfindungsgemäß durch die im kennzeichnenden Teil des Patentanspruchs 1 beanspruchten Merkmale gelöst.

Demnach sind ein Überprüfungsschritt, durch welchen feststellbar ist, ob alle, ausgewählte einzelne oder mehrere der bis dahin auszuführenden Speicherprogrammierungs-Steuervorgänge ausgeführt wurden, und ein Entscheidungsschritt, in welchem unter Berücksichtigung des Überprüfungsergebnisses entschieden wird, ob der Programmiervorgang unter Ausführung weiterer Speicherprogrammierungs-Steuervorgänge bestimmungsgemäß fortzusetzen ist, vorgesehen.

Das Vorsehen dieser Schritte ermöglicht zu jedem beliebigen Zeitpunkt eine Überprüfung, ob alle oder zumindest die wesentlichen der bestimmungsgemäß bis dahin auszuführenden Steuervorgänge tatsächlich auch ausgeführt oder statt dessen beispielsweise etwa ausgelassen oder unvollständig oder zu häufig ausgeführt worden sind. Legt man als die wesentlichen Steuervorgänge diejenigen Steuervorgänge fest, die die Entscheidung erlauben, ob der Steuerungsablauf, genauer gesagt der Ablauf der Veranlassung und der Durchführung des Löschens oder Überschreibens der programmierbaren Speichereinrichtung bis zum betrachteten Zeitpunkt bestimmungsgemäß erfolgte, kann das Überprüfungsergebnis im Entscheidungsschritt zur Entscheidung herangezogen werden, ob die Einleitung und/oder die Durchführung des Löschens oder Überschreibens der programmierbaren Speichereinrichtung auf die hierfür vorgesehene Art und Weise vonstatten ging oder etwa durch eine Störung oder Fehlfunktion ausgelöst oder beeinflußt wurde.

In Abhängigkeit von der im Entscheidungsschritt getroffenen Entscheidung kann dann der weitere Betrieb des Steuergerätes individuell festgelegt werden. Für den Fall, daß im Entscheidungsschritt festgestellt wird, daß eine im Überprüfungsschritt überprüfte Bedingung nicht erfüllt ist, d.h. ein oder mehrere Speicherprogrammierungs-Steuervorgänge bestimmungswidrig nicht oder zumindest nicht ordnungsgemäß ausgeführt wurden, erscheint es angebracht, die normale (bestimmungsgemäße) Fortführung der Speicherprogrammierungs-Steuervorgänge zu unterbinden; anderenfalls besteht kein Anlaß, regulierend einzugreifen.

Durch das Vorsehen der genannten Verfahrensschritte wurde mithin ein Verfahren geschaffen, durch welches ein durch Störungen ausgelöstes und/oder beeinflußtes Löschen und/oder Überschreiben von in einer programmierbaren Speichereinrichtung gespeicherten Daten auf einfache Weise weitestgehend ausschließbar ist.

Vorteilhafte Weiterbildungen der Erfindung sind Gegenstand der Unteransprüche.

Die Erfindung wird nachfolgend anhand eines Ausführungsbeispiels näher erläutert.

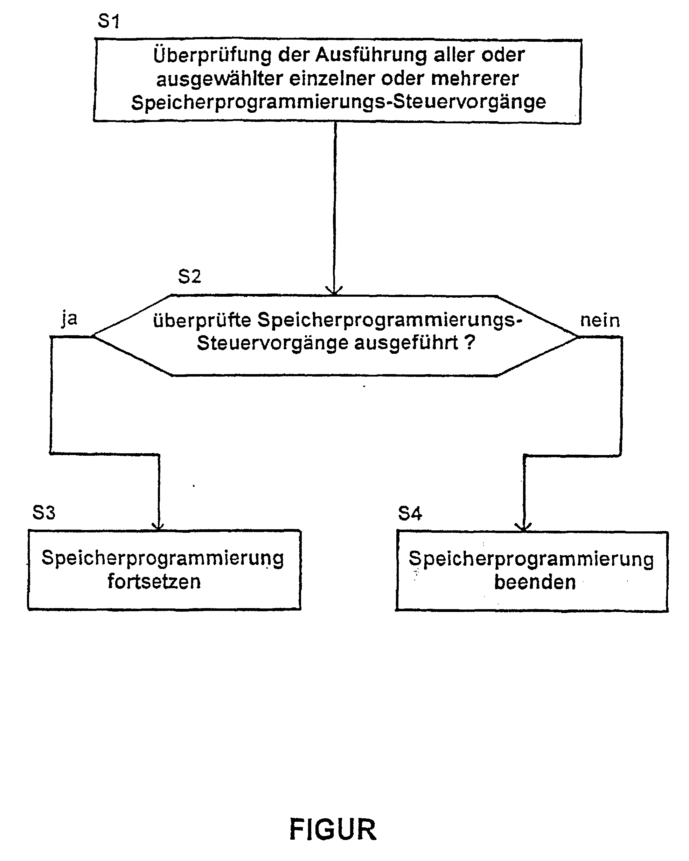

Die Figur zeigt einen Ablaufplan eines Ausführungsbeispieles des erfindungsgemäßen Verfahrensabschnittes.

Die nachstehenden Erläuterungen betreffen ein Verfahren zum Betreiben eines Steuergerätes, insbesondere eines Steuergerätes zur Steuerung beispielsweise des Motors, des Getriebes der Bremsen etc. eines Kraftfahrzeuges, also eines Kraftfahrzeugsteuergerätes.

Das Steuergerät enthält programmierbare Speichereinrichtungen, genauer gesagt löschbare nichtflüchtige Speichereinrichtungen in Form von Flash-EPROMs, deren besondere Vorzüge für diesen Anwendungsbereich bereits eingangs erwähnt wurden.

Die Programmierung der Speichereinrichtungen erfolgt über ein externes Programmiergerät, das beispielsweise über eine serielle Schnittstelle mit dem Kraftfahrzeugsteuergerät verbindbar ist.

Die vorliegende Erfindung ist jedoch nicht auf die Programmierung von Flash-EPROMs in Kraftfahrzeugsteuergeräten unter Verwendung eines externen Programmiergerätes beschränkt. Sie ist vielmehr überall dort anwendbar, wo es ganz allgemein darum geht, eine Speichereinrichtung eines Steuergerätes durch eine Programmiervorrichtung zu programmieren.

Das Programmieren, genauer gesagt das Löschen und/oder das Überschreiben der Speichereinrichtung erfolgt durch ein aufeinanderfolgendes Ausführen von Speicherprogrammierungs-Steuervorgängen, auf welche später noch genauer eingegangen werden wird.

Die Ausführung der Speicherprogrammierungs-Steuervorgänge, welche - sofern keine Störung vorliegt - im wesentlichen durch das externe Programmiergerät veranlaßt wird, erfolgt unter Abarbeitung von Steuerprogrammen, welche im Steuergerät gespeichert sind. Die zur Speicherung der Steuerprogramme verwendete Speichereinrichtung kann, muß aber nicht das in Rede stehende Flash-EPROM sein.

Beim Aufruf des genannten Steuerprogramms wird dieses in einen einer Steuereinheit wie einem Mikroprozessor, Mikrocontroller oder dergleichen zugeordneten Arbeitsspeicher geladen und unter Abarbeitung durch die Steuereinheit ausgeführt.

Um verhindern zu können, daß ein durch eine versehentliche, mißbräuchliche oder nicht ordnungsgemäße Ausführung des Steuerprogramms, also ein durch Störungen ausgelöstes und/oder beeinflußtes Löschen und/oder Überschreiben von in einer programmierbaren Speichereinrichtung gespeicherten Daten erfolgt, wird - beispielsweise durch Ausführung eines in der Figur veranschaulichten und im folgenden näher beschriebenen Ablaufüberwachungsprogramms - eine Ablaufüberwachung durchgeführt.

In einem Schritt S1 des in der Figur veranschaulichten Ablaufüberwachungsprogramms erfolgt eine Überprüfung der Ausführung aller oder ausgewählter einzelner oder mehrerer Speicherprogrammierungs-Steuervorgänge.

Die Speicherprogrammierungs-Steuervorgänge, deren Ausführungen hier vorzugsweise zu überprüfen sind, sind insbesondere Überprüfungsroutinen, die ihrerseits wiederum ebenfalls das Vorliegen vorbestimmter Bedingungen überprüfen.

Die durch die Überprüfungsroutinen zu überprüfenden Bedingungen sind dabei im vorliegenden Ausführungsbeispiel vor allem solche Bedingungen, deren Nichtbeachtung zu Fehlsteuerungen, d.h. im betrachteten Fall speziell zu einem versehentlichen und/oder mißbräuchlichen Löschen und/oder Überschreiben des Flash-EPROM führen kann.

Im vorliegenden Ausführungsbeispiel wurden als zu überprüfende Bedingungen fünf Bedingungen (Bedingung (1) bis (5)) ausgewählt, die nachfolgend näher beschrieben werden.

Die Bedingung (1), die es zu überprüfen gilt, betrifft das Anliegen einer sogenannten Programmierspannung an einem entsprechenden Eingangsanschluß des Steuergerätes. Bei der Überprüfung dieser Bedingung (1) durch die entsprechende Überprüfungsroutine wird ermittelt, ob die Programmierspannung anliegt.

Das Anlegen der genannten Programmierspannung an das Steuergerät ist eine der Maßnahmen, durch die das externe Programmiergerät dem Steuergerät und/oder dem Flash-EPROM signalisiert, daß eine Programmierung oder Umprogrammierung des Flash-EPROM erfolgen soll. Wenn und so lange die genannte Programmierspannung am Steuergerät nicht anliegt, ist es aus Gründen der Sicherheit unabhängig von den sonstigen Umständen angebracht, durch Vornahme einer entsprechenden Ablaufsteuerung von einer Programmierung (Umprogrammierung) bzw. einem Löschen des Flash-EPROM abzusehen.

Zur weiteren Erhöhung der Sicherheit kann in Betracht gezogen werden, nicht nur das Anliegen einer beliebigen, von Null verschiedenen Spannung am entsprechenden Eingangsanschluß des Steuergerätes zu überprüfen, sondern gleichzeitig die Höhe der gegebenenfalls anliegenden Spannung auszuwerten, um eine Spannung nur dann als ordnungsgemäß anliegend zu betrachten, wenn diese einen unteren und einen oberen Grenzwert nicht unter- bzw. überschreitet.

Die Bedingung (2), die es zu überprüfen gilt, betrifft die Initialisierung des Steuergerätes. Bei der Überprüfung dieser Bedingung durch die entsprechende Überprüfungsroutine wird ermittelt, ob das Steuergerät auf eine für eine Programmierung des Flash-EPROM vorgesehene Art und Weise initialisiert wurde.

Das betrachtete Steuergerät kann sich in verschiedenen Betriebsarten befinden, die die Funktion und/oder Arbeitsweise des Steuergerätes unterschiedlich festlegen. Zum Löschen und/oder Überschreiben des Flash-EPROM ist eine spezielle Betriebsart vorgesehen, die sich von der "Normal"-Betriebsart und gegebenenfalls weiteren Betriebsarten des Steuergerätes unter anderem darin unterscheidet, daß die spezielle Betriebsart ein Löschen und/oder Überschreiben des Flash-EPROM besonders unterstützt. Der Eintritt des Steuergerätes in diese spezielle Betriebsart erfordert eine spezielle Initialisierung des Steuergerätes. Wenn und so lange eine derartige Initialisierung des Steuergerätes nicht durchlaufen wurde, ist es aus Gründen der Sicherheit unabhängig von den sonstigen Umständen angebracht, durch Vornahme einer entsprechenden Ablaufsteuerung von einer Programmierung (Umprogrammierung) bzw. einem Löschen des Flash-EPROM abzusehen.

Die Bedingung (3), die es zu überprüfen gilt, betrifft die Kommunikation zwischen dem Steuergerät und dem externen Programmiergerät. Bei der Überprüfung dieser Bedingung durch die entsprechende Überprüfungsroutine wird ermittelt, ob ein die ordnungsgemäße Kommunikation ermöglichendes Schnittstellenprotokoll aktiv ist.

Das Steuergerät und das externe Programmiergerät sind beim vorliegenden Ausführungsbeispiel über eine serielle Schnittstelle verbunden. Die Kommunikation über diese Schnittstelle bedarf einer speziellen Steuerung und Überwachung, was durch Aktivierung eines sogenannten Schnittstellenprotokoll bewerkstelligbar ist. Wenn und solange das entsprechende Schnittstellenprotokoll nicht aktiv ist, ist eine ordnungsgemäße Kommunikation zwischen dem Steuergerät und dem externen Programmiergerät nicht möglich, und aus Gründen der Sicherheit ist es in diesem Fall unabhängig von den sonstigen Umständen angebracht, durch Vornahme einer entsprechenden Ablaufsteuerung von einer Programmierung (Umprogrammierung) bzw. einem Löschen des Flash-EPROM abzusehen.

Die Bedingung (4), die es zu überprüfen gilt, betrifft das Vorliegen einer Anforderung zum Löschen und/oder Überschreiben des Flash-EPROM seitens des externen Programmiergerätes. Bei der Überprüfung dieser Bedingung durch die entsprechende Überprüfungsroutine wird ermittelt, ob eine derartige Anforderung vorliegt.

Zum Löschen und/oder Überschreiben des Flash-EPROM ist es nicht ausreichend, daß das Steuergerät und das externe Programmiergerät in die entsprechenden Betriebsarten versetzt sind und miteinander kommunizieren können. Hierzu bedarf es vielmehr einer expliziten Anforderung des Programmiergerätes an das Steuergerät. Wenn und so lange eine derartige Anforderung nicht vorliegt, ist es aus Gründen der Sicherheit unabhängig von den sonstigen Umständen angebracht, durch Vornahme einer entsprechenden Ablaufsteuerung von einer Programmierung (Umprogrammierung) bzw. einem Löschen des Flash-EPROM abzusehen.

Die vorstehend angesprochenen Bedingungen (1) bis (4) betreffen im wesentlichen die externe Veranlassung des Steuergerätes zum Programmieren (Umprogrammieren) bzw. zum Löschen des Flash-EPROM.

Die Bedingung (5), die es nun noch zu überprüfen gilt, betrifft den Ablauf des Löschens und/oder Überschreibens des Flash-EPROM selbst sowie die unmittelbar damit in Zusammenhang stehenden Maßnahmen. Bei der Überprüfung dieser Bedingung durch die entsprechende Überprüfungsroutine wird ermittelt, ob der Ablauf der hierzu erforderlichen Steuerungsvorgänge bestimmungsgemäß erfolgt.

Die zum Löschen und/oder Überschreiben des Flash-EPROM selbst sowie die unmittelbar damit in Zusammenhang stehenden Maßnahmen müssen zu bestimmten Zeitpunkten und/oder in einer bestimmten Reihenfolge und/oder in einer bestimmten Häufigkeit vorgenommen werden. Wenn sich in der Aufeinanderfolge der entsprechenden Steuervorgänge Abweichungen vom bestimmungsgemäßen Normalfall ergeben, ist es aus Gründen der Sicherheit unabhängig von den sonstigen Umständen angebracht, durch Vornahme einer entsprechenden Ablaufsteuerung von einer Programmierung (Umprogrammierung) bzw. einem Löschen des Flash-EPROM abzusehen.

Den Bedingungen (1) bis (5) ist, wie bei den entsprechenden Erläuterungen jeweils bereits erwähnt wurde, gemeinsam, daß von diesen die Reihenfolge, die Dauer und die Anzahl der Ausführungen der Speicherprogrammierungs-Steuervorgänge abhängt.

Die Bedingungen (1) bis (5) werden, wie vorstehend ebenfalls bereits erwähnt wurde, mittels Überprüfungsroutinen überprüft, und zwar je nach Bedarf beliebig oft, beliebig lange und zu beliebigen Zeitpunkten; die Ausführung dieser Überprüfungsroutinen wird wiederum in Schritt S1 des in der Figur gezeigten Ablaufüberwachungsprogramms überprüft.

Die Überprüfungsroutinen bzw. - allgemeiner ausgedrückt - die Speicherprogrammierungs-Steuervorgänge, deren Ausführung in Schritt S1 zu überprüfen ist, sind derart ausgebildet, daß sie während deren Ausführung Maßnahmen ergreifen, anhand derer zu einem beliebig späteren Zeitpunkt überprüft werden kann, ob, gegebenenfalls auch wie oft, wie lange und wann eine Ausführung erfolgt ist.

Eine derartige Maßnahme kann beispielsweise darin bestehen, daß eine zugeordnete Kennung (Flag) gesetzt oder gelöscht wird.

Eine andere Möglichkeit besteht darin, daß der Zählstand eines Zählers verändert wird, wobei die Art und der Umfang der Zählstands-Veränderung für jeden Speicherprogrammierungs-Steuervorgang, dessen Ausführung in Schritt S1 zu überprüfen ist, individuell festlegbar sind und bei Bedarf (zur Maximierung der Sicherheit) zusätzlich auch davon abhängig gemacht werden können, zum wievielten Mal, wie lange andauernd und zu welchem Zeitpunkt eine Ausführung eines jeweiligen Speicherprogrammierungs-Steuervorganges erfolgt.

Die in Schritt S1 durchgeführte Überprüfung erfolgt unter individueller Auswertung der entsprechenden Kennungen und/oder Zählstände.

In Schritt S2 wird entschieden, ob die Speicherprogrammierungs-Steuervorgänge, deren Ausführung in Schritt S1 überprüft wurde, tatsächlich (und ordnungsgemäß) ausgeführt wurden.

In Abhängigkeit vom Entscheidungsergebnis in Schritt S2 erfolgt eine Verzweigung entweder zu einem Schritt S3 oder zu einem Schritt S4.

Eine Verzweigung zu Schritt S3 findet statt, wenn in Schritt S2 entschieden wird, daß die Speicherprogrammierungs-Steuervorgänge, deren Ausführung in Schritt S1 überprüft wurde, ausgeführt oder ordnungsgemäß ausgeführt wurden. Die Verzweigung zu Schritt S3 hat zur Folge, daß die Speicherprogrammierung fortgesetzt wird, d.h. das Steuerprogramm zum Treffen weiterer Veranlassungen für die Speicherprogrammierung und zur Durchführung der Speicherprogrammierung selbst bestimmungsgemäß weiter abgearbeitet wird.

Eine Verzweigung zu Schritt S4 findet statt, wenn in Schritt S2 entschieden wird, daß die Speicherprogrammierungs-Steuervorgänge, deren Ausführung in Schritt S1 überprüft wurde, nicht oder nicht ordnungsgemäß (beispielsweise nur teilweise) ausgeführt wurden. Die Verzweigung zu Schritt S4 hat zur Folge, daß die Speicherprogrammierung beendet wird, d.h. das Steuerprogramm zum Treffen weiterer Veranlassungen für die Speicherprogrammierung und zur Durchführung der Speicherprogrammierung selbst vorzugsweise definiert verlassen wird.

Die Ausführung des beschriebenen Ablaufüberwachungsprogramms kann beispielsweise durch das die Ausführung der Speicherprogrammierungs-Steuervorgänge bewirkende Steuerprogramm veranlaßt werden, und zwar vorzugsweise als abschließende Überprüfung unmittelbar vor dem Löschen und/oder Überschreiben des Flash-EPROM.

Zusätzlich oder alternativ kann vorgesehen werden, die Ausführung des beschriebenen Ablaufüberwachungsprogramms im Ansprechen auf bestimmte Ereignisse (interruptgesteuert) zu veranlassen.

Die durch den Schritt S1 überwachbaren Speicherprogrammierungs-Steuervorgänge können unabhängig von der Veranlassung der Ablaufüberwachung einzeln oder in beliebig zusammengestellten Gruppen überprüft und ausgewertet werden. Jeder der Speicherprogrammierungs-Steuervorgänge kann unabhängig von den anderen Speicherprogrammierungs-Steuervorgängen beliebig oft (unter Umständen auch überhaupt nicht) und zu beliebigen Zeitpunkten zum Gegenstand der beschriebenen Überprüfung und Auswertung gemacht werden, so lange die jeweiligen Zeitpunkte nur vor dem eigentlichen Programmieren (Umprogrammieren) oder Löschen des Flash-EPROM liegen.

Alternativ oder zusätzlich zu den vorstehend beschriebenen Maßnahmen kann vorgesehen werden, daß Daten, von deren Inhalt das Löschen und/oder Überschreiben des Inhalts des Flash-EPROM abhängig machbar ist, nicht etwa jederzeit frei zugänglich im Steuergerät gespeichert sind, sondern erst nach dem Aufbau der Kommunikation zwischen dem Steuergerät und dem externen Programmiergerät (siehe die vorstehend erläuterte Bedingung (3)) auf Veranlassung des externen Programmiergerätes hin durch das Programmiergerät selbst oder das Steuergerät an eine hierfür vorgesehene Stelle in einen flüchtigen Speicher des Steuergerätes geschrieben werden.

Bei den genannten Daten kann es sich beispielsweise um diejenigen Daten und Adressenwerte handeln, die zumindest bei einigen Flash-EPROMs vor dem eigentlichen Löschen und/oder Überschreiben in Form sogenannter Entriegelungszyklen (unlock cycles) über den Bus zum Flash-EPROM gegeben werden müssen.

Ist die Ausführung dieser unlock cycles so ausgestaltet, daß die zu deren Ausführung herangezogenen Daten- und Adressenwerte von der genannten vorgesehenen Stelle in dem flüchtigen Speicher des Steuergerätes geholt werden, kann das Flash-EPROM nicht entriegelt und damit auch nicht programmiert werden, bevor auf Veranlassung des externen Steuergerätes hin die entsprechenden Daten an die hierzu vorgesehene Stelle transferiert werden.

Das Vorsehen der vorstehend beschriebenen Maßnahmen ermöglicht es, daß ein durch Störungen ausgelöstes und/oder beeinflußtes Löschen und/oder Überschreiben von in einer programmierbaren Speichereinrichtung gespeicherten Daten auf einfache Weise weitestgehend ausschließbar ist.

## Patentansprüche

1. Verfahren zum Betreiben eines Steuergerätes mit einer programmierbaren Speichereinrichtung, wobei das Programmieren der Speichereinrichtung unter aufeinanderfolgender Ausführung einer Vielzahl von Speicherprogrammierungs-Steuervorgängen erfolgt,
einen Überprüfungsschritt (S1), durch welchen feststellbar ist, ob alle, ausgewählte einzelne oder mehrere der bis dahin auszuführenden Speicherprogrammierungs-Steuervorgänge ausgeführt wurden, und
einen Entscheidungsschritt (S2), in welchem unter Berücksichtigung des Überprüfungsergebnisses entschieden wird, ob der Programmiervorgang unter Ausführung weiterer Speicherprogrammierungs-Steuervorgänge bestimmungsgemäß fortzusetzen ist, wobei die Ausführung der Speicherprogrammierungs-Steuervorgänge durch Abarbeitung von Steuerprogrammen erfolgt, **dadurch gekennzeichnet, daß** die Überprüfung, ob ein Speicherprogrammierungs-Steuervorgang ausgeführt wurde, durch eine Überprüfung, ob das zugeordnete Steuerprogramm oder der zugeordnete Steuerprogrammabschnitt durchlaufen wurde, bewerkstelligt wird.

2. Verfahren nach Anspruch 1, **dadurch gekennzeichnet, daß** die Steuerprogramme, deren Durchlaufen durch den Überprüfungsschritt (S1) überprüfbar sein soll, neben der Durchführung des eigentlichen Steuervorganges eine Veränderung des Zählstandes eines Zählers veranlassen.

3. Verfahren nach Anspruch 1 oder 2, **dadurch gekennzeichnet, daß** die Steuerprogramme, deren Durchlaufen durch den Überprüfungsschritt (S1) überprüfbar sein soll, neben der Durchführung des eigentlichen Steuervorganges ein Setzen oder Löschen einer zugeordneten Kennung veranlassen.

4. Verfahren nach einem der vorhergehenden Ansprüche, **dadurch gekennzeichnet, daß** die Programmierung der Speichereinrichtung nur veranlaßt oder fortgesetzt wird, wenn oder so lange erfaßt wird, daß von einem externen Programmiergerät eine vorbestimmte Spannung an einen Eingangsanschluß des Steuergerätes angelegt ist oder ein entsprechender Steuervorgang zur Überwachung dessen ausgeführt wird oder wurde.

5. Verfahren nach einem der vorhergehenden Ansprüche, **dadurch gekennzeichnet, daß** die Programmierung der Speichereinrichtung nur veranlaßt oder fortgesetzt wird, wenn oder so lange erfaßt wird, daß eine einer Programmierung der Speichereinrichtung normalerweise vorangehende Initialisierung des Steuergerätes erfolgt ist oder ein entsprechender Steuervorgang zur Überwachung dessen ausgeführt wird oder wurde.

6. Verfahren nach einem der vorhergehenden Ansprüche, **dadurch gekennzeichnet, daß** die Programmierung der Speichereinrichtung nur veranlaßt oder fortgesetzt wird, wenn oder so lange erfaßt wird, daß zwischen dem Steuergerät und einem externen Programmiergerät eine Kommunikation unter Einhaltung eines vorbestimmten Protokolls in Gang oder in Gang gesetzt ist oder ein entsprechender Steuervorgang zur Überwachung dessen ausgeführt wird oder wurde.

7. Verfahren nach einem der vorhergehenden Ansprüche, **dadurch gekennzeichnet, daß** die Programmierung der Speichereinrichtung nur veranlaßt oder fortgesetzt wird, wenn oder so lange erfaßt wird, daß eine entsprechende Anforderung eines externen Programmiergerätes vorliegt oder ein entsprechender Steuervorgang zur Überwachung dessen ausgeführt wird oder wurde.

8. Verfahren nach einem der vorhergehenden Ansprüche, **dadurch gekennzeichnet, daß** Adressen und Daten, die vor der Programmierung zur Entriegelung der Speichereinrichtung an entsprechende Anschlüsse derselben anzulegen sind, erst nach dem Ingangsetzen einer Kommunikation zwischen dem Steuergerät und einem externen Programmiergerät in einen flüchtigen Speicher des Steuergerätes geschrieben werden.

## Claims

1. Method for operating a control unit with a programmable memory device, the programming of the memory device being effected by successive execution of a multiplicity of memory programming control operations,
a checking step (S1), by means of which it can be ascertained whether all, selected individual ones or a plurality of the memory programming control operations to be executed by then have been executed, and
a decision step (S2), in which a decision is made, taking account of the checking result, as to whether the programming operation is to be continued as prescribed with execution of further memory programming control operations, the execution of the memory programming control operations being effected by the processing of control programs, **characterized in that** the checking as to whether a memory programming control operation has been executed is realized by a checking as to whether the assigned control program or the assigned control program section has been implemented.

2. Method according to Claim 1, **characterized in that** the control programs whose implementation is intended to be able to be checked by the checking step (S1) instigate an alteration of the count of a counter in addition to the carrying out of the actual control operation.

3. Method according to Claim 1 or 2, **characterized in that** the control programs whose implementation is intended to be able to be checked by the checking step (S1) instigate a setting or erasing of an assigned identifier in addition to the carrying out of the actual control operation.

4. Method according to one of the preceding claims, **characterized in that** the programming of the memory device is instigated or continued only if or as long as it is detected that a predetermined voltage has been applied to an input terminal of the control unit by an external programming unit or a corresponding control operation for monitoring this is being or has been executed.

5. Method according to one of the preceding claims, **characterized in that** the programming of the memory device is instigated or continued only if or as long as it is detected that an initialization of the control unit which normally precedes a programming of the memory device has been effected or a corresponding control operation for monitoring this is being or has been executed.

6. Method according to one of the preceding claims, **characterized in that** the programming of the memory device is instigated or continued only if or as long as it is detected that, between the control unit and an external programming unit, a communication complying with a predetermined protocol is in progress or has been put in progress or a corresponding control operation for monitoring this is being or has been executed.

7. Method according to one of the preceding claims, **characterized in that** the programming of the memory device is instigated or continued only if or as long as it is detected that a corresponding request from an external programming unit is present or a corresponding control operation for monitoring this is being or has been executed.

8. Method according to one of the preceding claims, **characterized in that** addresses and data which are to be applied to corresponding terminals of the memory device before the programming for unlocking the said memory device are written to a volatile memory of the control unit only after a communication between the control unit and an external programming unit has been put in progress.

## Revendications

1. Procédé d'utilisation d'un appareil de commande pourvu d'une mémoire programmable, dans lequel la programmation de la mémoire est effectuée par l'exécution successive d'une pluralité d'opérations de commande de programmation de la mémoire. Une étape de contrôle (S1), par laquelle on peut constater si toutes les opérations ou si certaines ou plusieurs opérations sélectionnées parmi les opérations à exécuter jusqu'à ce moment ont été exécutées, et une étape de décision (S2), dans laquelle on décide, compte tenu du résultat du contrôle, si l'opération de programmation doit être poursuivie comme prévu par l'exécution d'autres opérations de commande de programmation de la mémoire, étape dans laquelle l'exécution des opérations de commande de programmation de la mémoire est effectuée en exécutant des programmes de commande,
**caractérisé en ce que**
l'opération visant à contrôler si une opération de commande de programmation de la mémoire a été exécutée est réalisée en contrôlant si le programme de commande associé ou le segment de programme de commande associé a été exécuté.

2. Procédé selon la revendication 1,
**caractérisé en ce que**
les programmes de commande, dont l'exécution doit pouvoir être contrôlée par l'étape de contrôle (S1), provoquent un changement de l'état de comptage d'un compteur, en plus de l'exécution de l'opération de commande proprement dite.

3. Procédé selon la revendication 1 ou 2,
**caractérisé en ce que**
les programmes de commande, dont l'exécution doit pouvoir être contrôlée par l'étape de contrôle (S1), provoquent l'activation ou l'extinction d'une caractéristique associée, en plus de l'exécution de l'opération de commande proprement dite.

4. Procédé selon l'une quelconque des revendications précédentes,
**caractérisé en ce que**
la programmation de la mémoire n'est commencée ou poursuivie que si ou aussi longtemps que l'on détecte qu'une tension prédéterminée est appliquée par un appareil de programmation extérieur à une borne d'entrée de l'appareil de commande ou qu'une opération de commande correspondante pour la surveillance de cette opération est ou a été exécutée.

5. Procédé selon l'une quelconque des revendications précédentes,
**caractérisé en ce que**
la programmation de la mémoire n'est commencée ou poursuivie que si ou aussi longtemps qu'une initialisation de l'appareil de commande normalement préalable à une programmation de la mémoire a été effectuée ou qu'une opération de commande correspondante pour la surveillance de cette opération est ou a été exécutée.

6. Procédé selon l'une quelconque des revendications précédentes,
**caractérisé en ce que**
la programmation de la mémoire n'est commencée ou poursuivie que si ou aussi longtemps qu'une communication respectant un protocole prédéterminé est ou a été mise en route entre l'appareil de commande et un appareil de programmation extérieur ou qu'une opération de commande correspondante pour la surveillance de cette opération est ou a été exécutée.

7. Procédé selon l'une quelconque des revendications précédentes,
**caractérisé en ce que**
la programmation de la mémoire n'est commencée ou poursuivie que si ou aussi longtemps qu'il existe un appel correspondant d'un appareil de programmation extérieur ou qu'une opération de commande correspondante pour la surveillance de cette opération est ou a été exécutée.

8. Procédé selon l'une quelconque des revendications précédentes,
**caractérisé en ce que**
des adresses et des données, à appliquer aux bornes correspondantes de la mémoire avant la programmation pour le déverrouillage de la mémoire, ne sont inscrites dans une mémoire volatile de l'appareil de commande qu'après l'établissement d'une communication entre l'appareil de commande et un appareil de programmation extérieur.
